Europäisches Patentamt

European Patent Office

Office européen des brevets

(19)

(11) Publication number : **0 118 199**
**B1**

# EUROPEAN PATENT SPECIFICATION

(12)

(45) Date of publication of patent specification :
**01.10.86**

(51) Int. Cl.⁴ : **G 01 R 31/26**

(21) Application number : **84300626.3**

(22) Date of filing : **01.02.84**

(54) **An apparatus for measuring carrier lifetimes in a semiconductor.**

(30) Priority : **01.02.83 JP 15174/83**

(43) Date of publication of application :
**12.09.84 Bulletin 84/37**

(45) Publication of the grant of the patent :
**01.10.86 Bulletin 86/40**

(84) Designated contracting states :
**DE FR GB NL**

(56) References cited :
**EP-A- 0 077 021**
**US-A- 4 122 383**
**US-A- 4 211 488**
**US-A- 4 273 421**
**US-A- 4 333 051**

(73) Proprietor : **HITACHI, LTD.**
**6, Kanda Surugadai 4-chome Chiyoda-ku Tokyo 100 (JP)**

(72) Inventor : **Noriaki, Honma**
**2196-204, Hirai Hinodemachi**
**Nishitama-gun Tokyo (JP)**
Inventor : **Chusuke, Munakata**
**2196-91, Hirai Hinodemachi**
**Nishitama-gun Tokyo (JP)**

(74) Representative : **Calderbank, Thomas Roger et al**
**MEWBURN ELLIS & CO. 2/3 Cursitor Street**
**London EC4A 1BQ (GB)**

Note : Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

Jouve, 18, rue St-Denis, 75001 Paris, France

# 0 118 199

## Description

The present invention relates to a carrier lifetime measuring apparatus which measures minority carrier (current carrier) lifetime within a semiconductor sample on the basis of the frequency dependency of a photovoltage.

It is well known that the minority carrier lifetime of a semiconductor is a factor with a significant effect on the electrical characteristics of a semiconductor device. Therefore, the inspection of the minority carrier lifetime is an important consideration in the enhancement of the available percentage of a manufacturing process.

The inventors of the present invention have investigated a carrier lifetime measuring apparatus which measures the minority carrier lifetime within a semiconductor from the bending point of the frequency dependence of a photovoltage. This apparatus forms the subject of EP-A-0 077 021 published after the priority date of the present invention. In this apparatus, sample e. g. a p-Si wafer having a p-n junction is irradiated with radiation which has energy equivalent to or somewhat greater than the band gap of silicon (Si) (in the case of Si, infrared radiation at wavelengths of 1 to 1.15 μm) and which is chopped, to generate an alternating photovoltage, and this photovoltage $V_{ph}$ is detected by capacitance coupling between a transparent electrode and the sample, whereby the frequency dependency of the photovoltage is measured. Thus, the apparatus makes it possible to measure the minority carrier lifetime within the sample nondestructively and without forming an electrode on the sample.

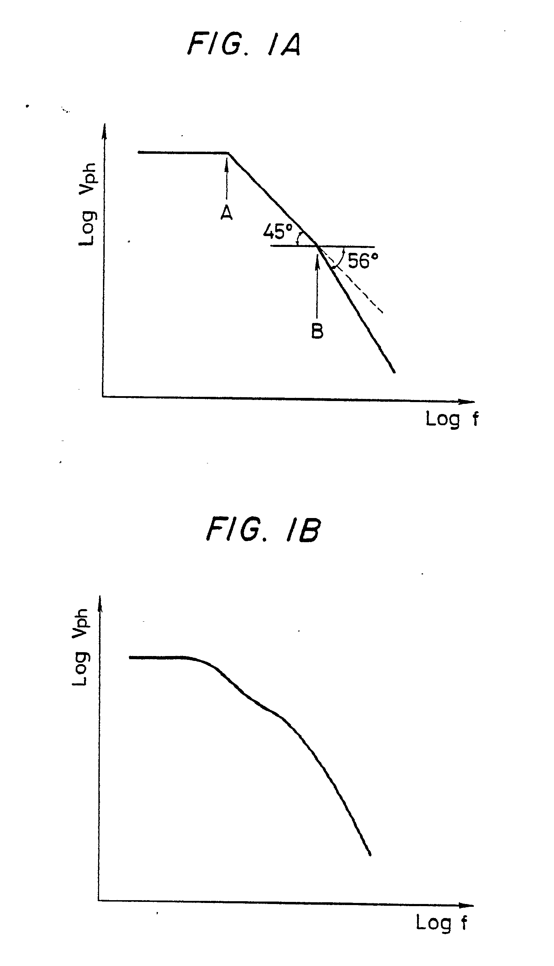

The lifetime τ of carriers at the point of irradiation of the sample is obtained from the relationship $\tau = 1/(2\pi f_o)$ where $f_o$ is the frequency of bending point, based on the carrier lifetime, which appears in the frequency dependence of the photovoltage when this frequency dependency is measured. The photovoltage $V_{ph}$ is constant at frequencies lower than the cutoff frequency $f_c$ of the junction. In contrast, it varies proportionally to $f^{-1}$ for frequencies exceeding $f_c$ (point A in Figure 1A of the accompanying drawings), and it varies proportionally to $f^{-3/2}$ for frequencies exceeding $f_o$ (point B in Figure 1A). Thus when the frequency characteristic of the photovoltage $V_{ph}$ is indicated by coordinates, both axes of which are logarithmically represented, as shown in Figure 1A, the frequency at the point at which the characteristic curve changes from a gradient of 45 degrees to a gradient of 56 degrees is used to determine the frequency $f_o$.

This apparatus, however, still involves problems as will now be described. Although the bending point of 45 degrees → 56 degrees is often observed for p-n junctions etc., effects due to the influence of the time constants of interface states or traps or surface states or traps are often observed in, for example, p-type Si bearing an oxide film or n-type Si subjected to an alkali surface treatment. The frequency dependence of the photovoltage in such cases is not certain to be a curve decreasing with an angle of inclination of 45 degrees for $f > f_c$, as seen from Figure 1B of the accompanying drawings. In addition, a new bending point sometimes appears. Therefore it is difficult to obtain $f_o$ from such samples, and there is then the problem that the carrier lifetime τ cannot be measured from the bending point of the frequency characteristic. Furthermore, changes in interelectrode capacitance, the input impedance of a photovoltage detector, etc. affect the frequency dependence of the photovoltage. Therefore, it must be confirmed that the observed bending point is truly based on the minority carrier lifetime, by, for example, a photoconductivity decay method which requires the formation of electrodes on the sample. Thus, if only the bending point of the frequency dependency of the photovoltage is used, there is a problem that the measured result lacks reliability.

The present invention seeks to overcome this problem. The solution to the problem involves the use of two light beams instead of a single beam. US-A-4 273 421 discloses an apparatus having a first light source adapted to generate a first photon beam of a wavelength having a relatively large optical absorption coefficient when incident on a semiconductor sample ; a second light source adapted to generate a second photon beam of a wavelength having a relatively small absorption coefficient when incident on the sample ; means for causing the first and second photon beams to be incident on the same point on the sample ; and signal processing means for determining the minority carrier lifetime at the point of incidence of the beams on the sample. This document therefore corresponds to the precharacterising part of claim 1.

In US-A-4 273 421 the two beams are incident simultaneously, and the minority carrier lifetime is determined by analysis of the phase difference between the two beams.

An apparatus according to the present invention seeks to improve the accuracy of the measurements of the minority carrier lifetime by having the means for causing the beams to be incident on the same point adapted so that each beam is incident alternately on that point. There is then means for detecting first and second photovoltages generated in the sample due to irradiation of the sample by the first and second photon beams respectively, and signal processing means adapted to evaluate the ratio between signals derived from the amplitudes of the first and second photovoltages, thereby to determine the minority carrier lifetime. Also, there is a sample holder for receiving the sample. The use of such an apparatus eliminates the effects of interface states and traps in the sample, and also may eliminate changes in circuit constants in the measuring system, thereby making possible an accurate determination of carrier lifetime.

2

If the photovoltages are detected by capacitance coupling of an electrode, the carrier lifetime may be measured without forming an electrode on the sample, as in the apparatus shown in EP-A-0 077 021.

The wavelengths of the light beams depend on the nature of the sample. In general, the beam with the small absorption coefficient will have a longer wavelength than the other beam.

An embodiment of the present invention will now be described, by way of example, with reference to be accompanying drawings in which :

Figures 1A and 1B are diagrams showing the frequency dependency of photovoltages, Figure 1A corresponding to the absence of the influence of surface states or traps and Figure 1B corresponding to the presence thereof ;

Figures 2A and 2B are diagrams of equivalent circuits for the measurements of photovoltages, Figure 2A corresponding to the absence of the influence of surface states or traps and Figure 2B corresponding to the presence thereof ;

Figure 3 is a block diagram of an embodiment of the present invention ;

Figure 4 is a block diagram showing an example of a signal processing circuit for use in the embodiment of the present invention shown in Figure 3 ; and

Figure 5 is a graph showing examples of alkali-treated n-type Si samples measured in accordance with the embodiment of Figure 3.

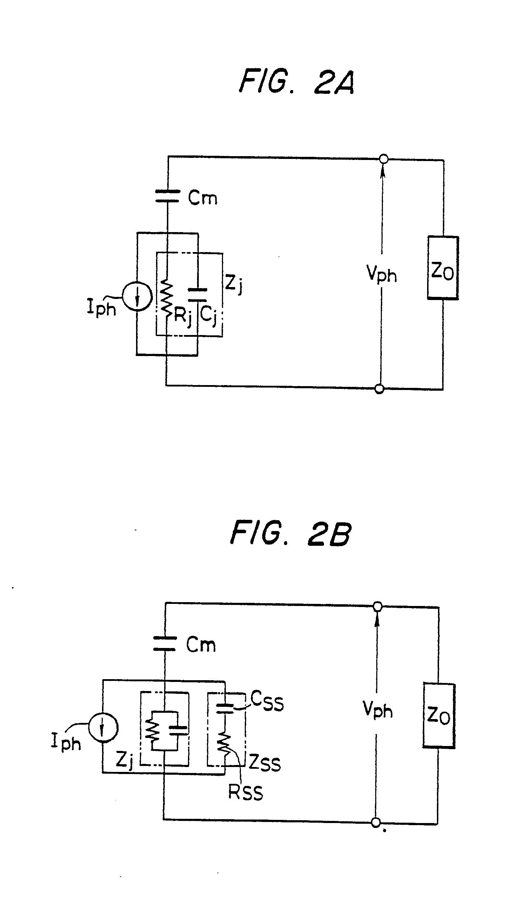

When a semiconductor sample having a potential barrier in the vicinity of its surface is irradiated with light, a photocurrent flows within the semiconductor due to the photovoltaic effect, and a photovoltage develops across the sample. When the light is chopped at a frequency f, both the photocurrent and the photovoltage become alternating. By providing a transparent electrode of an electric capacitor adjacent the surface of the sample, the photovoltage generated by the light can be measured using e. g. an A. C. voltmeter without contacting the sample surface. The basic electrical equivalent circuits of such a measuring system are shown in Figures 2A and 2B, Figure 2A corresponding to the absence of the influence of surface states or traps, and Figure 2B corresponding to the presence thereof.

A voltage $V_{ph}$ measured by the circuit of Figure 2A or 2B is expressed by :

$$V_{ph} = Z \cdot I_{ph} \tag{1}$$

Where $I_{ph}$ denotes the photocurrent, and Z an impedance represented by the following equation :

$$Z = \frac{Z_0 \cdot Z_j}{Z_0 + Z_j + 1/j \, 2 \, \pi f C_m} \tag{2}$$

Where : $j = \sqrt{-1}$, $Z_0$ is the input impedance of the A. C. voltmeter, $Z_j$ is the junction impedance of a semiconductor sample, and $C_m$ is a coupling capacitance formed by the transparent electrode. From Equation (1), the frequency dependency of $V_{ph}$ is determined by the frequency dependency of Z and that of $I_{ph}$. The frequency dependency of $I_{ph}$ is expressed by the following equation :

$$I_{ph} = e \cdot \Phi \cdot (1 - \oplus) \cdot \frac{\alpha L}{\alpha L + 1} \cdot S . \tag{3}$$

Where : e is the unit charge, $\Phi$ the number of photons per unit area and unit time, $\oplus$ the optical reflection coefficient, $\alpha$ the optical absorption coefficient, and S the area of the spot of light incident on the sample, L is a parameter which has the following frequency dependence, the carrier diffusion length being denoted by $L_o$ :

$$L = \sqrt{\frac{D\tau}{1 + j \, 2 \, \pi f \tau}} = \frac{L_0}{\sqrt{1 + j \, 2 \, \pi f \tau}} . \tag{4}$$

Where : $L_o = \sqrt{D\tau}$, D is the diffusion coefficient of carriers, and $\tau$ is the carrier lifetime.

When $\alpha$ is small enough for the relationship $\alpha L \ll 1$ to hold in Equation (3), $I_{ph} \alpha L$, and $I_{ph}$ decreases with the increase of f for $f \gg 1/\tau$ in accordance with Equation (4). Therefore, when the frequency $f = f_o = 1/2\pi\tau$ (below which $I_{ph}$ begins to decrease) is known the condition $2\pi f \tau = 1$ is established and the minority carrier lifetime $\tau$ can be evaluated.

For a p-n junction device or a semiconductor wafer having a strong inversion layer in its surface, Z can usually be approximated to an impedance $Z_j$ ($\omega$) in which a junction resistance $Z_j$ and a junction capacitance $C_j$ are connected in parallel as follows :

$$Z \fallingdotseq Z_j = \frac{R_j}{1 + j \, 2 \, \pi C_j \, R_j} . \tag{5}$$

Ultimately, the photovoltage $V_{ph}$ is given by the following equation :

$$V_{ph} = e\Phi (1 - \textcircled{H}) \alpha L_0 R_j \{ 1 + (2\pi f C_j R_j)^2 \}^{-1/2} \{ 1 + (2\pi f\tau)^2 \}^{-1/4} . \tag{6}$$

In general, $\tau < C_j R_j$. It may therefore be expected that, as the frequency is raised, the frequency dependency of $V_{ph}$ is a constant for $f < 1/(2\pi C_j R_j)$, $V_{ph} \alpha f^{-1}$ for $f > 1/(2\pi C_j R_j)$, and $V_{ph} \alpha f^{-3/2}$ for $f > 1/(2\pi\tau)$. Thus for a p-n junction or a semiconductor sample having a strong inversion layer in its surface, it is possible to obtain $f_o = 1/(2\pi\tau)$ from the frequency of that point of transition from the $f^{-1}$ dependency to the $f^{-3/2}$ dependency which appears in the frequency dependency of the photovoltage $V_{ph}$.

However, Z is not as indicated by Equation (5) when a weak inversion layer or a mere depletion layer exists in an interface or a surface and when interface states or traps or surface states or traps exist in large numbers. Then an impedance $Z_{ss}$ formed by an equivalent resistance $R_{ss}$ and capacitance $C_{ss}$ based on the surface states or traps are connected in series, is incorporated in parallel with $Z_j$ as shown in Figure 2B. In consequence, the $\omega^{-1}$ dependence does not occur even for $f > f_c$ as shown in Figure 1B, and $f_o$ cannot be defined as the frequency corresponding to the transition from an $f^{-1}$ dependence to an $f^{-3/2}$ dependence.

Now, going back to the starting point, it is evident that the condition to establish $2\pi f_o \tau = 1$ appears in the frequency dependency of the photocurrent and is independent of the frequency dependency of Z. As seen from Equation (1), when the frequency dependency of the photocurrent only can be measured, the influence of the surface states or traps appearing in the frequency dependence of Z can be eliminated, and the problem can be solved.

With note taken of the photocurrent $I_{ph}$ here, when the optical absorption coefficient $\alpha$ is large so that $\alpha L \gg 1$, it is clear from Equation (3) that $I_{ph} = I_K$ (constant), $I_{ph}$ being independent of frequency. The photovoltage $V_{ph}'$ is then given by the following equation :

$$V_{ph}' = Z \cdot I_K \tag{7}$$

On the other hand, if the optical absorption coefficient $\alpha$ is small so that $\alpha L \ll 1$, when the photovoltage is denoted by $V_{ph}''$, and the photocurrent by $I_{ph}''$, the following equation holds :

$$V_{ph}'' = Z \cdot I_{ph}'' \tag{8}$$

Thus, when the ratio between Equation (8) and Equation (7) is determined, the frequency dependency of the photocurrent $I_{ph}''$ is obtained as follows :

(normalized photovoltage ratio : $V_n$)

$$V_n = V_{ph}''/V_{ph}' = (1/I_K) \cdot I_{ph}'' \tag{9}$$

On the basis of this result, the frequency dependence of the photocurrent can be measured by evaluating the ratio of photovoltages generated by two light sources of a wavelength $\lambda_2$ such that the optical absorption coefficient $\alpha$ is small so that $\alpha L \ll 1$ and a wavelength $\lambda_1$ such that the optical absorption coefficient $\alpha$ is large so that $\alpha L \gg 1$. Thus, the measurement of the minority carrier lifetime becomes possible, not only for a p-n junction, but also for various semiconductor samples generating photovoltages.

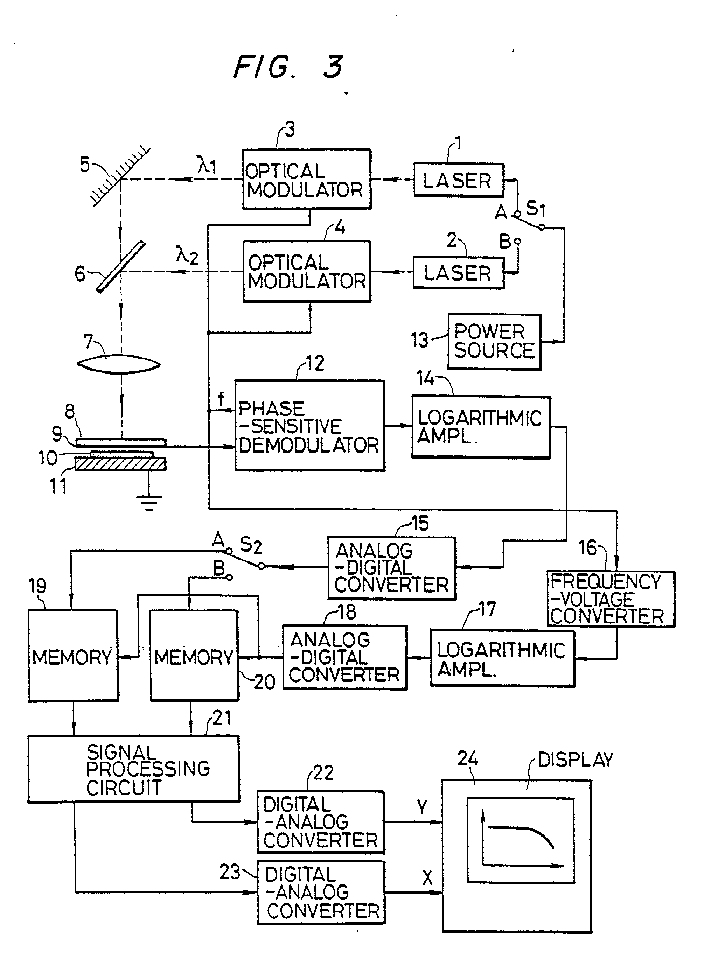

An embodiment of the present invention will now be described with reference to Figure 3. In the figure, a first laser 1 oscillates at a wavelength $\lambda_1$ of large absorption coefficient $\alpha$, and a second laser 2 oscillates at a wavelength $\lambda_2$ of small absorption coefficient $\alpha$. The lasers 1 and 2 are powered by a laser power source 13, and selection of laser 1 or laser 2 is achieved by changing-over a switch $S_1$ to side A or side B as appropriate. Optical modulators 3 and 4 receive the reference signal of a phase-sensitive demodulator 12 as input signals and respectively chop the radiations of wavelengths $\lambda_1$ and $\lambda_2$ at a frequency f of the reference signal.

If laser diodes or light emitting diodes (LEDs) are used to form the lasers 1 and 2, their driving currents can be modulated directly, so that the optical modulators 3 and 4 may be omitted and a reduction in the size of the apparatus becomes possible. The radiation from the first laser 1 is reflected by a mirror 5. A dichroic mirror 6 transmits radiation of wavelength $\lambda_1$ reflected from the mirror 5 and reflects radiation of wavelength $\lambda_2$ from the second laser 2. With these components, the system is adjusted so that, after light of wavelength $\lambda_1$ reflected by the mirror 5 and light of wavelength $\lambda_2$ from the optical modulator 4 have come out of the dichroic mirror 6, their optical paths coincide. A sample 10 is placed on a sample holder 11 which is made of metal and which serves as an electrode. A flat glass plate 8 which is provided with a transparent electrode 9 as an underlying layer is located over the sample 10 with a spacing of at most 100 $\mu m$ therebetween. The light from the dichroic mirror 6 is focussed onto the sample 10 by a lens 7. A photovoltage generated between the electrode 9 and the holder 11 is detected by the phase-sensitive demodulator 12 and is subjected to logarithmic transform by a logarithmic amplifier 14, whereupon the transformed voltage is digitized by an analog-digital converter 15. The frequency f of the reference signal of the phase-sensitive demodulator 12 is converted into a voltage signal by an FV (frequency-voltage) converter 16. Thereafter, the voltage signal is subjected to logarithmic transform by a logarithmic amplifier 17 and is digitized by an analog-digital converter 18. The digital output signal of the A/D converter 18 is stored as frequency information in memories 19 and 20. The digital output signal of the A/D converter 15 is stored in the memory 19 or 20 and is changed-over by means of a switch $S_2$ which interlocks with switch $S_1$. That is, when the switches $S_1$ and $S_2$ are connected to the A side, data for the wavelength $\lambda_1$ is stored in the memory 19, and when they are connected to the B side, data for the wavelength $\lambda_2$ is stored in the memory 20. Thus the values of Log $V_{ph}$ and Log f are respectively stored as digital signals in the memories 19 and 20. After measurement at wavelengths $\lambda_1$ and $\lambda_2$ has ended, the stored contents are read out from the memories 19 and 20, the difference between Log $V_{ph}$ for $\lambda_1$ and Log $V_{ph}$ for $\lambda_2$ is calculated by a signal processing circuit 21. The output of the signal processing circuit 21 is converted to an analog signal by digital-analog converter 22, and the analog signal is inputted to the Y-axis of a display unit 24. Furthermore, a digital signal having information corresponding to Log f is converted to an analog signal by a digital-analog converter 23, and the analog signal is inputted to the Xaxis of the display unit 24. In this way, a characteristic in which Log f is displayed on the Xaxis and a value proportional to Log $I_{ph}$ is displaced on the Y-axis is presented on the display unit 24. By reading $f_o$ from the display, the minority carrier lifetime $\tau$ can be evaluated from $\tau = 1/(2\pi f_o)$.

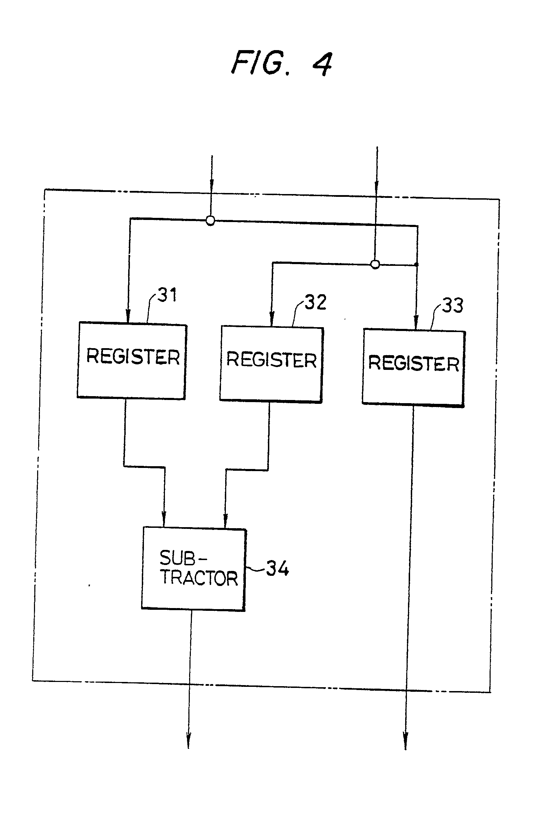

Figure 4 is a block diagram showing a practicable example of the signal processing circuit 21 described above. Of the signals read out from the memories 19 and 20 by address appointment, the signal representing the frequency is inputted to the D/A converter 23 via a register 33, the signal representing the photovoltage corresponding to a light wavelength $\lambda_1$ is inputted to a subtractor 34 via a register 31, and the signal representing the photovoltage corresponding to a wavelength $\lambda_2$ is inputted to subtractor 34 via a register 32. The ratio between the photovoltages derived from the two light sources is calculated by the subtractor 34, and is inputted to the D/A converter 22.

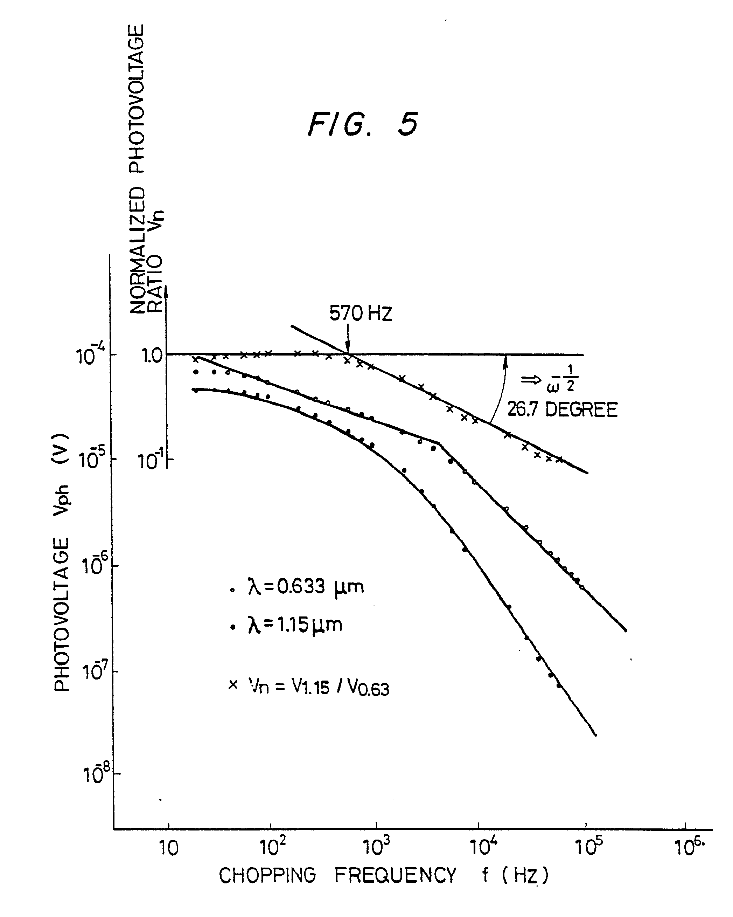

Figure 5 shows an example of measurement using such an apparatus. The samples were n-type silicon (Si), and each had dimensions of 5 mm × 5 mm × 56 mm. Light entered one of the 5 mm × 56 mm planes. A He-Ne laser beam oscillating at a wavelength $\lambda_2 = 1.15\ \mu m$ produced light with a wavelength of small absorption coefficient $\alpha$, while a He-Ne laser beam of a wavelength $\lambda_1 = 0.633\ \mu m$ produced light with a wavelength of large absorption coefficient $\alpha$. Black circles in Figure 5 represent the results at the wavelength $\lambda_2$. A photovoltage variation proportional to $f^{-1}$ does not appear when only the results of the black circles are considered, even for frequencies exceeding the cutoff frequency, and the bending point which gives the minority carrier lifetime cannot be determined. Therefore, a curve indicated by white circles corresponding to measurements with light of wavelength $\lambda_1 = 0.633\ \mu m$ is also considered, and the ratios of the results at $\lambda_2 = 1.15\ \mu m$ and $\lambda_1 = 0.633\ \mu m$ are determined and then normalized by the maximum value. The results thus obtained are a curve indicated by marks X. From this curve, it is seen that the characteristic is flat and parallel to the abscissa when the frequency f is not higher than 570 Hz, whereas it is inclined to the abscissa with an inclination proportional to $\omega^{-1/2}$ in a region which exceeds 570 Hz. This characteristic demonstrates the frequency dependency of the photocurrent. From this characteristic, the frequency $f_o$ is determined to be 570 Hz. Thus a value of 280 $\mu s$ is obtained for the minority carrier lifetime $\tau$.

As described above, according to the present invention, the frequency dependency of a photocurrent included in the frequency dependency of a photovoltage can be measured without being affected by interface states or traps or surface states or traps. This produces the very significant effect that the absolute value of a minority carrier lifetime can be measured from the frequency of a bending point appearing in the frequency dependency of the photocurrent, irrespective of the type of photovoltage generation such as at a p-n junction or in p-type Si bearing an oxide film. In addition, since the influences of fluctuations attendant upon the setting of a sample, e. g., a coupling capacitance $C_m$ are removed, a measurement of high reliability is possible, and the measurement may be achieved without contacting the sample and nondestructively.

## Claims

1. A carrier lifetime measuring apparatus comprising :

a first light source (1) adapted to generate a first photon beam of a wavelength ($\lambda_1$) having a relatively large optical absorption coefficient when incident on a semiconductor sample (10) ;

a second light source (2) adapted to generate a second photon beam of a wavelength ($\lambda_2$) having a relatively small optical absorption coefficient when incident on the sample (10) ;

means (3, 4, 5, 6, 7, 12, 13, S1) for causing the first and second photon beams to be incident on the same point of incidence on the sample (10) ; and

signal processing means (15, 19, 20, 21, 22, 23, 24) for determining the minority carrier lifetime at the point of incidence of the beams on the sample ;

characterised in that :

the means (3, 4, 5, 6, 7, 12, 13, S1) for causing the beams to be incident on the same point is adapted to cause the beams to be incident alternately on that point :

the apparatus also includes a sample holder (11) for receiving the sample (10), and means (8, 9) for detecting first and second photovoltages generated in the sample due to irradiation of the sample by the first and second photon beams respectively ; and

the signal processing means (15, 19, 20, 21, 22, 23, 24) is adapted to evaluate the ratio between signals derived from the amplitudes of the first and second photovoltages, thereby to determine the minority carrier lifetime.

2. An apparatus according to claim 1, wherein the means (8, 9) for detecting the first and second voltages operates by capacitance coupling with the sample (10).

3. An apparatus according to claim 1 or claim 2, wherein the means (3, 4, 5, 6, 7, 12, 13, S1) for causing the first and second beams to be incident alternately on the sample includes means (3, 4) for chopping the beams.

4. An apparatus according to claim 1 or claim 2, wherein the means (3, 4, 5, 6, 7, 12, 13, S1) for causing the first and second beams to be incident alternately on the sample includes means for controlling the output of the light sources (1, 2).

5. An apparatus according to any one of the preceding claims, wherein the signal processing means (15, 19, 20, 21, 22, 23, 24) includes two memories (19, 20) for storing the signals derived from the amplitude of the first and second photon beams respectively.

## Patentansprüche

1. Apparatur zur Messung der Ladungsträger-Lebensdauer mit

einer ersten Lichtquelle (1) zur Erzeugung eines ersten Photonenstrahls einer Wellenlänge ($\lambda_1$), der bei Auftreffen auf eine Halbleiterphobe (10) einen verhältnismäßig großen optischen Absorptionskoeffizient aufweist,

einer zweiten Lichtquelle (2) zur Erzeugung eines zweiten Photonenstrahls einer Wellenlänge ($\lambda_2$), der bei Auftreffen auf die Probe (10) einen verhältnismäßig kleinen optischen Absorptionskoeffizient aufweist,

einer Einrichtung (3, 4, 5, 6, 7, 12, 13, S1), die bewirkt, daß der erste und der zweite Photonenstrahl auf den gleichen Auftreffpunkt auf der Probe (10) auftreffen, und

einer Signalverarbeitungseinrichtung (15, 19, 20, 21, 22, 23, 24) zur Bestimmung der Lebensdauer der Minoritätsträger am Auftreffpunkt der Strahlen auf der Probe,

dadurch gekennzeichnet,

daß die Einrichtung (3, 4, 5, 6, 7, 12, 13, S1), die bewirkt, daß die Strahlen auf den gleichen Punkt auftreffen, so ausgelegt ist, daß sie bewirkt, daß die Strahlen abwechselnd auf diesen Punkt auftreffen,

daß die Apparatur ferner einen Probenhalter (11) zur Aufnahme der Probe (10) und eine Einrichtung (8, 9) zur Ermittlung einer ersten und einer zweiten Photospannung aufweist, die in der Probe aufgrund der Bestrahlung der Probe mit dem ersten bzw. dem zweiten Photonenstrahl erzeugt werden, und

daß die Signalverarbeitungseinrichtung (15, 19, 20, 21, 22, 23, 24) so ausgelegt ist, daß sie das Verhältnis zwischen aus den Amplituden der ersten und der zweiten Photospannung abgeleiteten Signalen auswertet, um die Lebensdauer der Minoritätsträger zu bestimmen.

2. Apparatur nach Anspruch 1, wobei die Einrichtung (8, 9) zur Ermittlung der ersten und der zweiten Spannung mittels kapazitiver Kopplung an die Probe (10) arbeitet.

3. Apparatur nach Anspruch 1 oder 2, wobei die Einrichtung (3, 4, 5, 6, 7, 12, 13, S1), die bewirkt, daß der erste und der zweite Strahl abwechselnd auf die Probe auftrifft, eine Einrichtung (3, 4) zum Zerhacken der Strahlen aufweist.

4. Apparatur nach Anspruch 1 oder 2, wobei die Einrichtung (3, 4, 5, 6, 7, 12, 13, S1), die bewirkt, daß der erste und der zweite Strahl abwechselnd auf die Probe auftrifft, eine Einrichtung zur Steuerung des Ausgangs der Lichtquellen (1, 2) aufweist.

5. Apparatur nach einem der vorhergehenden Ansprüche, wobei die Signalverarbeitungseinrichtung (15, 19, 20, 21, 22, 23, 24) zwei Speicher (19, 20) zur Speicherung der von der Amplitude des ersten bzw. des zweiten Photonenstrahls abgeleiteten Signale aufweist.

## Revendications

1. Appareil pour mesurer la durée de vie des porteurs de charge comprenant :

une première source de lumière (1) apte à produire un premier faisceau de photons possédant une longueur d'onde ($\lambda_1$) et présentant un coefficient d'absorption optique relativement élevé lorsqu'il tombe sur un échantillon semiconducteur (10) ;

une seconde source de lumière (2) apte à produire un second faisceau de photons possédant une longueur d'onde ($\lambda_2$) et présentant un coefficient d'absorption optique relativement faible lorsqu'il tombe sur l'échantillon (10) ;

des moyens (3, 4, 5, 6, 7, 12, 13, S1) servant à amener les premier et second faisceaux de photons à tomber au même point d'incidence sur l'échantillon (10) ; et

des moyens (15, 19, 20, 21, 22, 23, 24) de traitement de signaux, servant à déterminer la durée de vie des porteurs minoritaires au point d'incidence des faisceaux sur l'échantillon ;

caractérisé en ce que :

les moyens (3, 4, 5, 6, 7, 12, 13, S1) servant à amener les faisceaux à tomber sur le même point sont aptes à amener les faisceaux à tomber en alternance en ce point ;

l'appareil comporte également un porte-échantillon (11) pour recevoir l'échantillon (10) et des moyens (8, 9) servant à détecter de première et seconde tensions photoélectriques produites dans l'échantillon par suite de l'irradiation de ce dernier respectivement par les premier et second faisceaux de photons,

les moyens (15, 19, 20, 21, 22, 23, 24) de traitement de signaux sont aptes à évaluer le rapport entre des signaux dérivés des amplitudes des première et seconde tensions photoélectriques, ce qui permet de déterminer la durée de vie des porteurs minoritaires.

2. Appareil selon la revendication 1, dans lequel les moyens (8, 9) servant à détecter les première et seconde tensions fonctionnent au moyen d'un couplage capacitif avec l'échantillon (10).

3. Appareil selon la revendication 1 ou 2, dans lequel les moyens (3, 4, 5, 6, 7, 12, 13, S1) servant à amener les premier et second faisceaux à tomber en alternance sur l'échantillon comprennent des moyens (3, 4) pour hacher les faisceaux.

4. Appareil selon la revendication 1 ou 2, dans lequel les moyens (3, 4, 5, 6, 7, 12, 13, S1) servant à amener les premier et second faisceaux à tomber en alternance sur l'échantillon comprennent des moyens pour commander le signal de sortie des sources de lumière (1, 2).

5. Appareil selon l'une quelconque des revendications précédentes, dans lequel les moyens (15, 19, 20, 21, 22, 23, 24) de traitement de signaux comprennent deux mémoires (19, 20) servant à mémoriser les signaux dérivés respectivement de l'amplitude des premier et second faisceaux de photons.

FIG. IA

FIG. IB

# FIG. 2A

# FIG. 2B

# FIG. 3

# FIG. 4

FIG. 5